# EUROPEAN PATENT SPECIFICATION

(11) **EP 3 364 031 B1**
(45) Date of publication and mention of the grant of the patent: **13.05.2020**
(21) Application number: 18156345.3
(22) Date of filing: 12.02.2018
(51) Int. Cl.: F04B 39/12, F04B 45/047

(54) **MINIATURE GAS TRANSPORTATION DEVICE**
MINIATURGASTRANSPORTVORRICHTUNG
DISPOSITIF DE TRANSPORT DE GAZ MINIATURE

(30) Priority: 20.02.2017 TW 106105637
(43) Date of publication of application: 22.08.2018
(73) Proprietor: Microjet Technology Co., Ltd, Hsinchu (TW)
(72) Inventor: Liao, Jia-Yu, Hsinchu (TW); Chen, Shih-Chang, Hsinchu (TW); Liao, Hung-Hsin, Hsinchu (TW); Huang, Chi-Feng, Hsinchu (TW); Han, Yung-Lung, Hsinchu (TW)
(74) Representative: 2K Patentanwälte Blasberg Kewitz & Reichel

(56) References cited:
- EP-A1- 2 306 019
- WO-A1-2015/178104
- US-A1- 2016 010 636
- US-A1- 2016 201 665

## Description

### FIELD OF THE INVENTION

The present invention relates to a miniature gas transportation device, and more particularly to a slim and silent miniature gas transportation device.

### BACKGROUND OF THE INVENTION

With the advancement of science and technology, fluid transportation devices used in many sectors such as pharmaceutical industries, computer techniques, printing industries or energy industries are developed toward elaboration and miniaturization. The fluid transportation devices are important components that are used in for example micro pumps, micro atomizers, printheads or industrial printers. Therefore, it is important to provide an improved structure of the fluid transportation device.

For example, in the pharmaceutical industries, pneumatic devices or pneumatic machines use motors or pressure valves to transfer gases. However, due to the volume limitations of the motors and the pressure valves, the pneumatic devices or the pneumatic machines are bulky in volume. In other words, the conventional pneumatic device fails to meet the miniaturization requirement, and is not suit to be installed in or cooperatively operated with a portable equipment. Moreover during operations of the motor or the pressure valve, annoying noise is readily generated. That is, the conventional pneumatic device is neither friendly nor comfortable to the user.
The documents US 2016/201655 A1, WO 2015/178104A1, US 2016/10636 A1 and EP 2306019 A1 show technical background of the invention

As known, the gas-inputting mechanism and the gas-outputting mechanism of the conventional miniature gas transportation device are composed of different components. In other words, many components are required to achieve the purpose of inputting and outputting the gas. Since the number of the required components is very huge, the process of assembling the conventional miniature gas transportation device is complicated.

Therefore, there is a need of providing a miniature gas transportation device with small, miniature, silent, portable and comfortable benefits and less number of components in order to eliminate the above drawbacks.

### SUMMARY OF THE INVENTION

The present invention provides a miniature gas transportation device for a portable or wearable equipment or machine. The miniature gas transportation device includes a gas outlet plate. The gas outlet plate is a single component that is able to input and output the gas simultaneously. Consequently, the number of components in the miniature gas transportation device is reduced, and the fabricating process is simplified.

In accordance with an aspect of the present invention, there is provided a miniature gas transportation device. The miniature gas transportation device includes a gas outlet plate, a resonance plate, a piezoelectric actuator and a covering member. The gas outlet plate includes a gas outlet pipe, a gas outlet hole and plural protrusion structures. The gas outlet pipe is disposed on a first surface of the gas outlet plate. The gas outlet hole is formed in the gas outlet pipe and runs through the gas outlet plate for outputting a gas from the miniature gas transportation device. The plural protrusion structures are disposed on a second surface of the gas outlet plate. A space between every two adjacent protrusion structures of the plural protrusion structures is defined as a vent portion. The resonance plate includes a central aperture corresponding to the gas outlet hole of the gas outlet plate. The piezoelectric actuator is aligned with the resonance plate. The covering member includes a sidewall and a bottom plate. The sidewall is protruding from the edges of the bottom plate. An accommodation space is defined by the sidewall and the bottom plate collaboratively. The resonance plate and the piezoelectric actuator are accommodated within the accommodation space. The gas outlet plate, the resonance plate, the piezoelectric actuator and the covering member are stacked on each other sequentially. A convergence chamber is formed between the gas outlet plate and the resonance plate, A first chamber is formed between the covering member and the resonance plate. When the piezoelectric actuator is actuated to perform a gas-collecting operation, the gas is fed into the convergence chamber through the vent portion, transferred to the first chamber through the central aperture of the resonance plate, and temporarily stored in the first chamber. When the piezoelectric actuator is actuated to perform a gas-releasing operation, the gas is transferred from the first chamber to the convergence chamber through the central aperture of the resonance plate and discharged from the gas outlet hole.

The above contents of the present invention will become more readily apparent to those ordinarily skilled in the art after reviewing the following detailed description and accompanying drawings, in which:

### BRIEF DESCRIPTION OF THE DRAWINGS

FIG. 1A is a schematic exploded view illustrating a miniature gas transportation device according to an embodiment of the present invention and taken along a front side;
FIG. 1B is a schematic exploded view illustrating the miniature gas transportation device according to the embodiment of the present invention and taken along a rear side;
FIG. 2A is a schematic perspective view illustrating the piezoelectric actuator of the miniature gas transportation device according to the embodiment of the present invention and taken along the front side;
FIG 2B is a schematic perspective view illustrating the piezoelectric actuator of the miniature gas transportation device according to the embodiment of the present invention and taken along the rear side;
FIG. 2C is a schematic cross-sectional view illustrating the piezoelectric actuator of the miniature gas transportation device according to the embodiment of the present invention;
FIG. 3A is a schematic top view illustrating the miniature gas transportation device according to the embodiment of the present invention;
FIG. 3B is a schematic cross-sectional view illustrating the miniature gas transportation device of FIG. 3A and taken along the line A-A;
FIG. 3C is a schematic cross-sectional view illustrating the miniature gas transportation device of FIG. 3A and taken along the line B-B; and
FIGS. 4A to 4D schematically illustrate the actions of the miniature gas transportation device according to the embodiment of the present invention.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

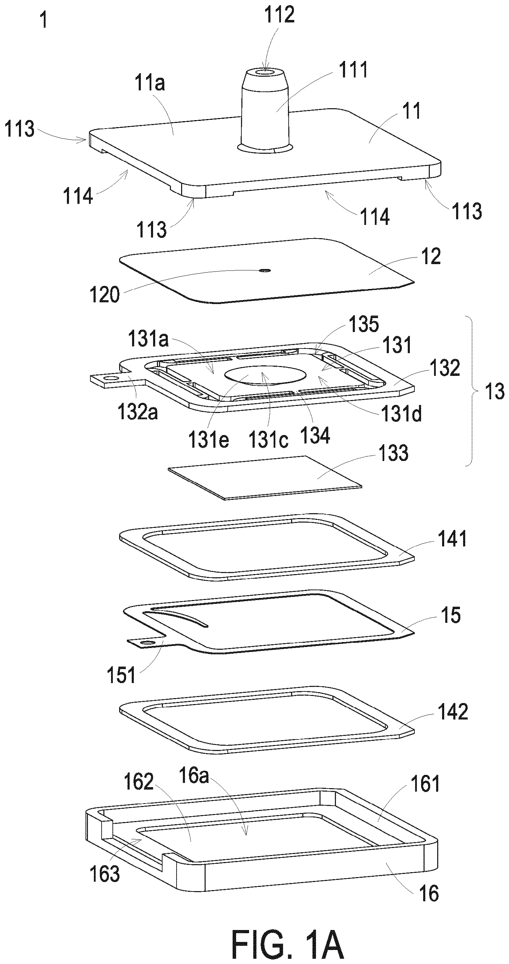

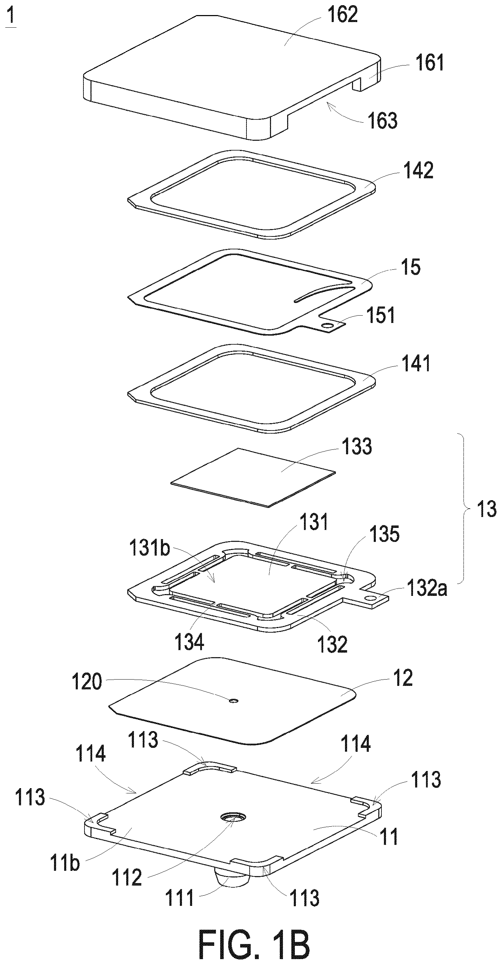

FIG. 1A is a schematic exploded view illustrating a miniature gas transportation device according to an embodiment of the present invention and taken along a front side. FIG. 1B is a schematic exploded view illustrating the miniature gas transportation device according to the embodiment of the present invention and taken along a rear side.

In this embodiment, the miniature gas transportation device 1 comprises a gas outlet plate 11, a resonance plate 12, a piezoelectric actuator 13 and a covering member 16. The gas outlet plate 11 comprises a gas outlet pipe 111, a gas outlet hole 112 and plural protrusion structures 113. The gas outlet pipe 111 is disposed on a first surface 11a of the gas outlet plate 11. The gas outlet hole 112 is formed in the gas outlet pipe 111 and runs through the gas outlet plate 11 for discharging the gas in the miniature gas transportation device 1. The plural protrusion structures 113 are disposed on a second surface 11b of the gas outlet plate 11. The space between every two adjacent protrusion structures 113 is defined as a vent portion 114 for allowing the ambient gas to be introduced into the miniature gas transportation device 1.

The resonance plate 12 has a central aperture 120 corresponding to the gas outlet hole 112 of the gas outlet plate 11.

The piezoelectric actuator 13 comprises a suspension plate 131, an outer frame 132 and a piezoelectric element 133. The suspension plate 131 comprises a middle portion 131c and a periphery portion 131d. When the piezoelectric element 133 is subjected to the curvy vibration in response to an applied voltage, the suspension plate 131 is subjected to the curvy vibration from the middle portion 131c to the periphery portion 131d. The outer frame 132 is arranged around the suspension plate 131, including but not limited to at least one bracket 134 and at least one conducting pin 132a. Each of the at least one bracket 134 is arranged between the suspension plate 131 and the outer frame 132. The two ends of the bracket 134 are connected to the suspension plate 131 and the outer frame 132, respectively. Consequently, the bracket 134 can elastically support the suspension plate 131. The conducting pin 132a is protruding outwardly from the outer frame 132 so as to be electrically connected with an external power source (not shown). The length of a side of the piezoelectric element 133 is smaller than or equal to the length of a side of the suspension plate 131, but not limited herein. The piezoelectric element 133 is attached on a second surface 131b of the suspension plate 131. When the piezoelectric element 133 is subjected to deformation in response to an applied voltage, the suspension plate 131 is subjected to a curvy vibration.

The covering member 16 comprises a sidewall 161, a bottom plate 162 and an opening 163. The sidewall 161 is protruding from the edges of the bottom plate 162. Moreover, an accommodation space 16a is defined by the sidewall 161 and the bottom plate 162 collaboratively. The resonance plate 12 and the piezoelectric actuator 13 are accommodated within the accommodation space 16a. The opening 163 is formed in the sidewall 161. The conducting pin 132a of the outer frame 132 is protruding out of the covering member 16 through the opening 163 so as to be electrically connected with an external circuit (not shown), but not limited herein.

The protrusion structures 113 of the gas outlet plate 11 are disposed on plural corners of the gas outlet plate 11. That is, the protrusion structures 113 of the gas outlet plate 11 are protruding from the corresponding corners of the gas outlet plate 11. Preferably, the protrusion structures 113 are integrally formed with the gas outlet plate 11.

The miniature gas transportation device 1 further comprises a first insulation plate 141, a conducting plate 15 and a second insulation plate 142. The first insulation plate 141 is located over the conducting plate 15. The second insulation plate 142 is located under the conducting plate 15. The shapes of the first insulation plate 141 and the second insulation plate 142 substantially match the shape of the outer frame 132 of the piezoelectric actuator 13. The first insulation plate 141 and the second insulation plate 142 are made of an insulating material (e.g. a plastic material) for providing insulating efficacy. The conducting plate 15 is made of an electrically conductive material (e.g. a metallic material) for providing electrically conducting efficacy. The shape of the conducting plate 15 substantially matches the shape of the outer frame 132 of the piezoelectric actuator 13. Moreover, the conducting plate 15 has a conducting pin 151 so as to be electrically connected with an external circuit (not shown). Similarly, the conducting pin 151 is protruding out of the covering member 16 through the opening 163 so as to be electrically connected with an external circuit (not shown).

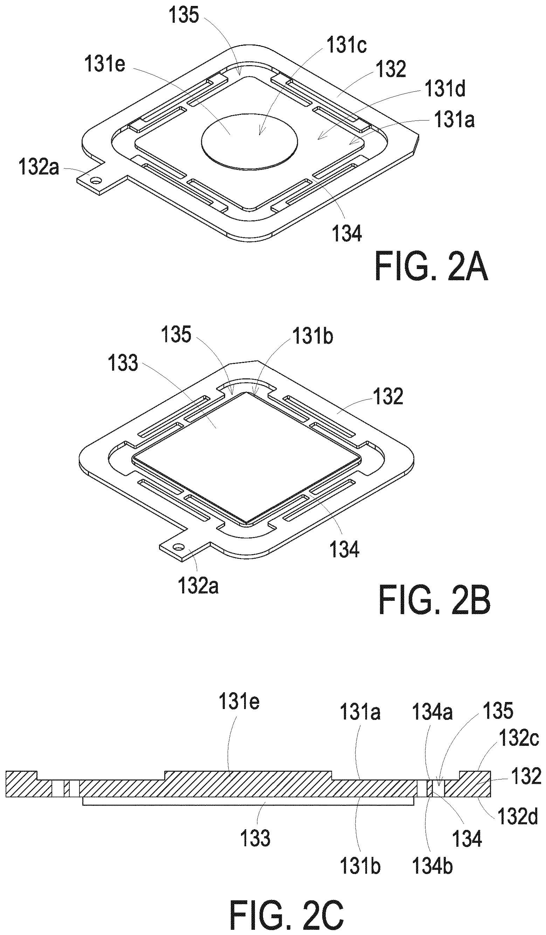

FIG. 2A is a schematic perspective view illustrating the piezoelectric actuator of the miniature gas transportation device according to the embodiment of the present invention and taken along the front side. FIG. 2B is a schematic perspective view illustrating the piezoelectric actuator of the miniature gas transportation device according to the embodiment of the present invention and taken along the rear side. FIG. 2C is a schematic cross-sectional view illustrating the piezoelectric actuator of the miniature gas transportation device according to the embodiment of the present invention. In this embodiment, the suspension plate 131 is a stepped structure. That is, the suspension plate 131 comprises a bulge 131e. The bulge 131e is formed on the first surface 131a of the suspension plate 131 and located at the middle portion 131c. For example, the bulge 131e is a circular convex structure such as a cylinder. In some embodiments, the suspension plate 131 is a square plate structure with two flat surfaces without the bulge 131e.

Please refer to FIG. 2C again. A top surface of the bulge 131e of the suspension plate 131 is coplanar with a first surface 132c of the outer frame 132, and the first surface 131a of the suspension plate 131 is coplanar with a first surface 134a of the bracket 134. Moreover, the bulge 131e of the suspension plate 131 (or the first surface 132c of the outer frame 132) has a specified thickness with respect to the first surface 131a of the suspension plate 131 (or the first surface 134a of the bracket 134). A second surface 131b of the suspension plate 131, the second surface 132d of the outer frame 132 and a second surface 134b of the bracket 134 are coplanar with each other. The piezoelectric element 133 is attached on the second surface 131b of the suspension plate 131. In some other embodiments, the suspension plate 131 is a square plate structure with two flat surfaces. That is, the structure of the suspension plate 131 may be varied according to the practical requirements. In this embodiment, the suspension plate 131, the outer frame 132 and the at least bracket 134 are integrally formed and produced by using a metal plate (e.g., a stainless steel plate). Moreover, at least one vacant space 135 is formed between the suspension plate 131, the outer frame 132 and the bracket 134 for allowing the gas to go through.

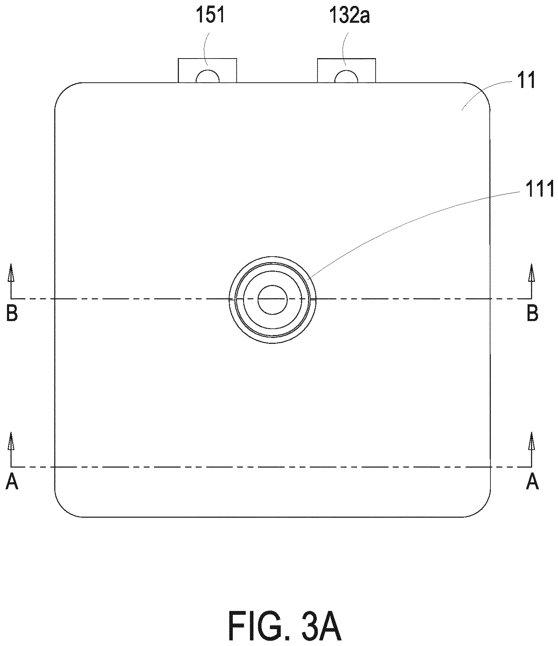

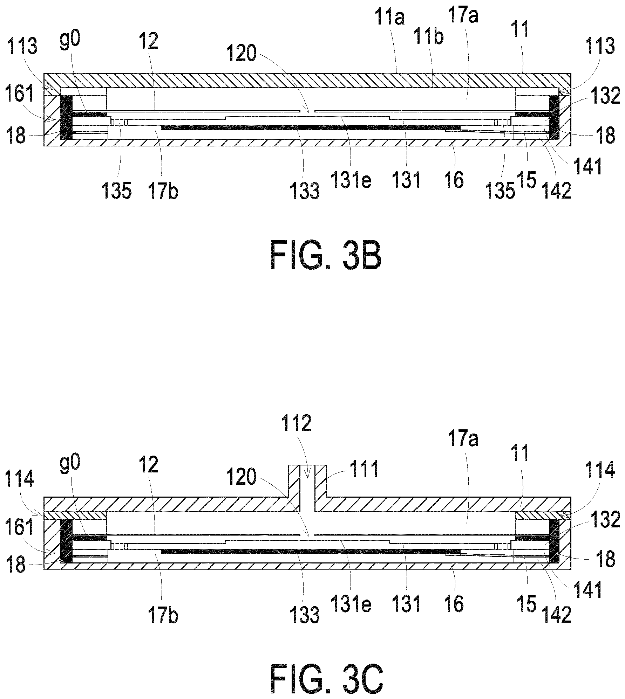

The inner structure and the outer structure of the miniature gas transportation device 1 will be described as follows. FIG 3A is a schematic top view illustrating the miniature gas transportation device according to the embodiment of the present invention. FIG. 3B is a schematic cross-sectional view illustrating the miniature gas transportation device of FIG. 3A and taken along the line A-A. FIG. 3C is a schematic cross-sectional view illustrating the miniature gas transportation device of FIG. 3A and taken along the line B-B. From top to bottom, the gas outlet plate 11, the resonance plate 12, the piezoelectric actuator 13, the first insulation plate 141, the conducting plate 15, the second insulation plate 142 and the covering member 16 of the miniature gas transportation device 1 are stacked on each other sequentially, wherein the peripheries of the piezoelectric actuator 13, the first insulation plate 141, the conducting plate 15 and the second insulation plate 142 are coated with glue to form a glue layer 18. The glue layer 18 is filled in the accommodation space 16a (see FIG. 1A) of the covering member 16 and seal the peripheries of the components. Consequently, the miniature gas transportation device 1 is assembled.

As shown in FIG. 3A, the miniature gas transportation device 1 has a square profile. It is noted that the profile of the miniature gas transportation device 1 may be varied according to the practical requirements. Moreover, the conducting pin 151 of the conducting plate 15 and the conducting pin 132a of the piezoelectric actuator 13 are protruding over the gas outlet plate 11 so as to be electrically connected with an external power source.

Please refer to FIGS. 3B and 3C. After the miniature gas transportation device 1 is assembled, a convergence chamber 17a is formed between the gas outlet plate 11 and the resonance plate 12, and a first chamber 17b is formed between the covering member 16 and the resonance plate 12. As mentioned above, the plural protrusion structures 113 are disposed on the second surface 11b of the gas outlet plate 11. After the miniature gas transportation device 1 is assembled, the plural protrusion structures 113 are abutting against the top side of the sidewall 161 of the covering member 16, so that a space in between the second surface 11b of the gas outlet plate 11 and the covering member 16 is maintained, and the height of the space is equal to the height of the protrusion structures 113, as shown in FIG. 3B. Due to the above-mentioned space, the convergence chamber 17a is in communication with the surroundings through the vent portions 114, each of which is defined in between two adjacent protrusion structures 113. Consequently, the convergence chamber 17a can collect gas from the surroundings through the vent portion 114.

In this embodiment, there is a gap g0 between the resonance plate 12 and the piezoelectric actuator 13. Moreover, a filler (e.g. a conductive adhesive) is inserted into the gap g0. Consequently, the depth of the gap g0 between the resonance plate 12 and the bulge 131e of the suspension plate 131 can be maintained to guide the gas to flow more quickly. Moreover, due to the proper distance between bulge 131e of the suspension plate 131 and the resonance plate 12, the contact interference is reduced and the generated noise is largely reduced. In some embodiments, the height of the outer frame 132 of the piezoelectric actuator 13 is increased, so that the gap is formed between the resonance plate 12 and the piezoelectric actuator 13.

When the piezoelectric actuator 13 is actuated to perform a gas-collecting operation, the gas is fed into the convergence chamber 17a through the vent portion 114, transferred to the first chamber 17b through the central aperture 120 of the resonance plate 12, and temporarily stored in the first chamber 17b. When the piezoelectric actuator 13 is actuated to perform a gas-releasing operation, the gas is transferred from the first chamber 17b to the convergence chamber 17a through the central aperture 120 of the resonance plate 12 and discharged from the gas outlet hole 112 of the gas outlet plate 11.

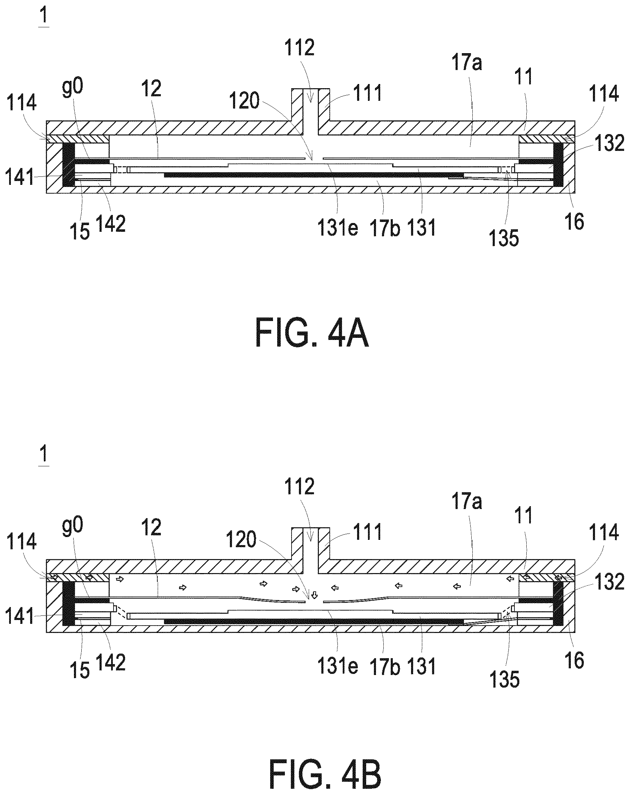

The operations of the miniature gas transportation device 1 will be described as follows. FIGS. 4A to 4D schematically illustrate the actions of the miniature gas transportation device according to the embodiment of the present invention.

Please refer to FIG. 4A, which shows an initial state of the miniature gas transportation device 1 not in action. After the gas outlet plate 11, the resonance plate 12, the piezoelectric actuator 13, the first insulation plate 141, the conducting plate 15, the second insulation plate 142 and the covering member 16 are stacked on each other sequentially, the miniature gas transportation device 1 is assembled. There is a gap g0 between the resonance plate 12 and the piezoelectric actuator 13. The convergence chamber 17a is formed between the gas outlet plate 11 and the resonance plate 12. The first chamber 17b is formed between the covering member 16 and the resonance plate 12.

Please refer to FIG. 4B. When the piezoelectric actuator 13 of the miniature gas transportation device 1 is actuated, the piezoelectric actuator 13 is vibrated downwardly in response to the applied voltage. Consequently, the ambient gas is converged into the convergence chamber 17a through the vent portion 114 of gas outlet plate 11, and then transferred downwardly to the first chamber 17b through the central aperture 120 of the resonance plate 12. Due to the resonance effect of the suspension plate 131 of the piezoelectric actuator 13, the resonance plate 12 is vibrated in a reciprocating manner. That is, the resonance plate 12 is subjected to a downward deformation. As shown, the portion of the resonance plate 12 around the central aperture 120 is protruding downwardly.

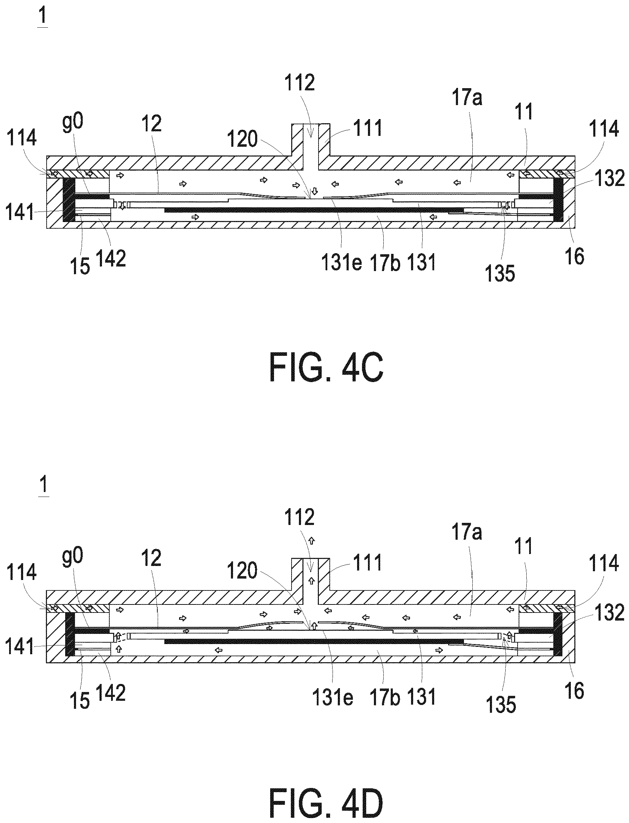

Please refer to FIG. 4C. The piezoelectric actuator 13 is vibrating upwardly and has returned to its original position. Meanwhile, the bulge 131e of the suspension plate 131 of the piezoelectric actuator 13 is moving towards the resonance plate 12. Consequently, the gas in the upper portion of the first chamber 17b is pushed toward peripheral regions of the upper portion of the first chamber 17b. Then, the gas is transferred downwardly through the vacant space 135 of the piezoelectric actuator 13, and temporarily stored in the lower portion of the first chamber 17b. From the above discussions, it can be seen that when the resonance plate 12 is vibrating along the vertical direction in the reciprocating manner, the gap g0 between the resonance plate 12 and the piezoelectric actuator 13 is helpful to increase the amplitude of vibration of the resonance plate 12. That is, the proper gap g0 between the resonance plate 12 and the piezoelectric actuator 13 allows the maximum amplitude of vibration of the resonance plate 12.

Please refer to FIG. 4D. Then, the resonance plate 12 is vibrating upwardly. The gas in the first chamber 17b is transferred into the convergence chamber 17a through the central aperture 120 of the resonance plate 12. As the air pressure in the convergence chamber 17a continuously increases, the gas is discharged from the gas outlet hole 112 of the gas outlet plate 11. Then, the resonance plate 12 is returned to the original position of FIG. 4A.

The processes of FIGS. 4A to 4D are repeatedly done. Consequently, the gas is continuously fed into the convergence chamber 17a through the vent portion 114, and transferred to the first chamber 17b. Then, the gas is transferred from the first chamber 17b to the convergence chamber 17a, and discharged from the gas outlet hole 112 of the gas outlet plate 11. Finally, the gas is transferred to the device (not shown) that is connected with the gas outlet pipe 111. Consequently, the gas can be transferred in a steady way. When the miniature gas transportation device 1 is operating, the gas is sequentially transferred through the vent portion 114 of the gas outlet plate 11, the convergence chamber 17a, the first chamber 17b, the convergence chamber 17a and the gas outlet hole 112 of the gas outlet plate 11. As mentioned above, the gas outlet plate 11 of the miniature gas transportation device 1 is a single component that is able to input and output the gas simultaneously. Consequently, the number of components in the miniature gas transportation device 1 is reduced, and the fabricating process is simplified.

From the above descriptions, the present invention provides the miniature gas transportation device. The plural protrusion structures are disposed on the gas outlet plate. The space between every two adjacent protrusion structures is defined as the vent portion. The ambient gas can be introduced into the miniature gas transportation device through the vent portion. After the gas is fed into the convergence chamber through the vent portion of the gas outlet plate, the gas is transferred to the first chamber through the central aperture of the resonance plate. As the piezoelectric actuator is actuated, the gas is transferred from the first chamber to the convergence chamber and discharged from the gas outlet hole of the gas outlet plate. In other words, the gas outlet plate is a single component that is able to input and output the gas simultaneously. Consequently, the number of components in the miniature gas transportation device is reduced, and the fabricating process is simplified. Due to the cooperation of the piezoelectric actuator and the gap between the piezoelectric actuator and the resonance plate, the gas can be quickly transferred while achieving silent efficacy. Moreover, due to the special configurations, the miniature gas transportation device of the present invention has small volume and small thickness. Consequently, the miniature gas transportation device is portable and suitably applied to medical equipment or any other appropriate equipment. In other words, the miniature gas transportation device of the present invention has industrial values.

## Claims

1. A miniature gas transportation device (1), comprising:
a gas outlet plate (11) comprising a gas outlet pipe (111), a gas outlet hole (112) and plural protrusion structures (113), wherein the gas outlet pipe (111) is disposed on a first surface (11a) of the gas outlet plate (11), and the gas outlet hole (112) is formed in the gas outlet pipe (111) and runs through the gas outlet plate (11) to output a gas from the miniature gas transportation device (1), wherein the plural protrusion structures (113) are disposed on a second surface (11b) of the gas outlet plate (11), and a space between every two adjacent protrusion structures (113) of the plural protrusion structures (113) is defined as a vent portion (114);
a resonance plate (12) comprising a central aperture (120) corresponding to the gas outlet hole (112) of the gas outlet plate (111);
a piezoelectric actuator (13) corresponding to the resonance plate (12); and
a covering member (16) comprising a bottom plate (162),
wherein the gas outlet plate (11), the resonance plate (12), the piezoelectric actuator (13) and the covering member (16) are stacked on each other sequentially to be positioned, a convergence chamber (17a) is formed between the gas outlet plate (11) and the resonance plate (12), and a first chamber (17b) is formed between the covering member (16) and the resonance plate (12), wherein when the piezoelectric actuator (13) is actuated to perform a gas-collecting operation, the gas is converged into the convergence chamber (17a), transferred to the first chamber (17b) through the central aperture (120) of the resonance plate (12), and temporarily stored in the first chamber (17b), wherein when the piezoelectric actuator (13) is actuated to perform a gas-releasing operation, the gas is transferred from the first chamber (17b) to the convergence chamber (17a) through the central aperture (120) of the resonance plate (12) and discharged from the gas outlet hole (112), **characterized in that**:
- a space between every two adjacent protrusion structures (113) of the plural protrusion structures (113) is defined as a vent portion (114);
- the covering member (16) comprises a sidewall (161) protruding from edges of the bottom plate (162), an accommodation space (16a) is defined by the sidewall (161) and the bottom plate (162) collaboratively, and the resonance plate (12) and the piezoelectric actuator (13) are accommodated within the accommodation space (16a),
- the device is so configured that when the piezoelectric actuator (13) is actuated to perform the gas-collecting operation, the gas is converged into the convergence chamber (17a) through the vent portion (114).

2. The miniature gas transportation device (1) according to claim 1, wherein the protrusion structures (113) are disposed on plural corners of the gas outlet plate (11), and the protrusion structures (113) are protruding from the corresponding corners of the gas outlet plate (11).

3. The miniature gas transportation device (1) according to claim 1 or 2, wherein the protrusion structures (113) are integrally formed with the gas outlet plate (11).

4. The miniature gas transportation device (1) according to any of the claims 1 to 3, wherein a gap (g0) is formed between the resonance plate (12) and the piezoelectric actuator (13).

5. The miniature gas transportation device (1) according to any of the claims 1 to 4, wherein the piezoelectric actuator (13) comprises:
a suspension plate (131) having a first surface (131a) and an opposing second surface (131b), wherein the suspension plate (131) is permitted to undergo a curvy vibration;
an outer frame (132) arranged around the suspension plate (131);
at least one bracket (134) connected between the suspension plate (131) and the outer frame (132) for elastically supporting the suspension plate (131); and
a piezoelectric element (133), wherein the length of a side of the piezoelectric element (133) is smaller than or equal to the length of a side of the suspension plate (131), and the piezoelectric element (133) is attached on the second surface (131b) of the suspension plate (131), wherein the piezoelectric element (133) drives curvy vibration of the suspension plate (131) when being applied to a voltage.

6. The miniature gas transportation device (1) according to any of the claims 1 to 5, wherein the miniature gas transportation device (1) further comprises at least one insulation plate (141, 142) and a conducting plate (15), wherein the at least one insulation plate (141, 142) and the conducting plate (15) are sequentially disposed beneath the piezoelectric actuator (13).

7. The miniature gas transportation device (1) according to claim 6, wherein the outer frame (132) of the piezoelectric actuator (13) comprises a first conducting pin (132a), the conducting plate (15) comprises a second conducting pin (151), and the covering member (16) comprises an opening (163) corresponding to the vent portion (114) of the gas outlet plate (11), wherein the first conducting pin (132a) and the second conducting pin (151) are protruding out of the opening (163) of the covering member (16) so as to be electrically connected with an external power source.

8. The miniature gas transportation device (1) according to any of the claims 5 to 7, wherein the suspension plate (131) further comprises a bulge (131e), and the bulge (131e) is formed on the first surface (131a) of the suspension plate (131).

9. The miniature gas transportation device (1) according to any of the claims 5 to 8, wherein the bulge (131e) of the suspension plate (131) is a cylinder.

10. The miniature gas transportation device (1) according to claim 5, wherein at least one vacant space (135) is formed between the at least one bracket (134), the suspension plate (131) and the outer frame (132).

11. The miniature gas transportation device (1) according to claims 5 to 10, wherein two ends of the at least one bracket (134) are connected to the outer frame (132) and the suspension plate (131), respectively.

## Patentansprüche

1. Eine Miniatur-Gastransportvorrichtung (1), umfassend:
eine Gasauslassplatte (11) mit einem Gasauslassrohr (111), einem Gasauslassloch (112) und mehreren Vorsprungsstrukturen (113), wobei das Gasauslassrohr (111) auf einer ersten Oberfläche (11a) der Gasauslassplatte (11) angeordnet ist und das Gasauslassloch (112) im Gasauslassrohr (111) ausgebildet ist und durch die Gasauslassplatte (11) verläuft, um ein Gas aus der Miniatur-Gastransportvorrichtung (1) auszugeben, wobei die mehreren Vorsprungsstrukturen (113) auf einer zweiten Oberfläche (11b) der Gasauslassplatte (11) angeordnet sind, und ein Raum zwischen jeweils zwei benachbarten Vorsprungsstrukturen (113) der mehreren Vorsprungsstrukturen (113) als ein Entlüftungsabschnitt (114) definiert ist;
eine Resonanzplatte (12) mit einer zentralen Öffnung (120), die dem Gasaustrittsloch (112) der Gasaustrittsplatte (111) entspricht;
einen piezoelektrischen Aktor (13), der der Resonanzplatte (12) entspricht; und
ein Abdeckelement (16) mit einer Bodenplatte (162),
wobei die Gasauslassplatte (11), die Resonanzplatte (12), der piezoelektrische Aktuator (13) und das Abdeckelement (16) aufeinander gestapelt sind, um nacheinander positioniert zu werden, eine Konvergenzkammer (17a) zwischen der Gasauslassplatte (11) und der Resonanzplatte (12) gebildet wird, und eine erste Kammer (17b) zwischen dem Abdeckelement (16) und der Resonanzplatte (12) gebildet wird, wobei, wenn der piezoelektrische Aktuator (13) betätigt wird, um einen Gassammelvorgang durchzuführen, das Gas in die Konvergenzkammer (17a) konvergiert, durch die zentrale Öffnung (120) der Resonanzplatte (12) in die erste Kammer (17b) überführt und in der ersten Kammer (17b) vorübergehend gespeichert wird, wobei, wenn der piezoelektrische Aktuator (13) zur Durchführung eines Gasfreigabevorgangs betätigt wird, das Gas von der ersten Kammer (17b) durch die zentrale Öffnung(120) der Resonanzplatte (12) in die Konvergenzkammer (17a) überführt und aus der Gasauslassöffnung (112) abgeführt wird, **dadurch gekennzeichnet, dass**
- ein Raum zwischen jeweils zwei benachbarten Vorsprungsstrukturen (113) der mehreren Vorsprungsstrukturen (113) als ein Entlüftungsteil (114) definiert ist;
- das Abdeckelement (16) eine Seitenwand (161) umfasst, die von den Rändern der Bodenplatte (162) vorsteht, ein Aufnahmeraum (16a) durch die Seitenwand (161) und die Bodenplatte (162) gemeinsam definiert wird und die Resonanzplatte (12) und der piezoelektrische Aktuator (13) in dem Aufnahmeraum (16a) untergebracht sind,
- die Vorrichtung so konfiguriert ist, dass, wenn der piezoelektrische Aktuator (13) zur Durchführung des Gassammelvorgangs betätigt wird, das Gas durch den Entlüftungsabschnitt (114) in die Konvergenzkammer (17a) konvergiert.

2. Die Miniatur-Gastransportvorrichtung (1) nach Anspruch 1, wobei die Vorsprungsstrukturen (113) an mehreren Ecken der Gasauslassplatte (11) angeordnet sind und die Vorsprungsstrukturen (113) aus den entsprechenden Ecken der Gasauslassplatte (11) vorstehen.

3. Die Miniatur-Gastransportvorrichtung (1) nach Anspruch 1 oder 2, wobei die Vorsprungsstrukturen (113) einstückig mit der Gasauslassplatte (11) ausgebildet sind.

4. Die Miniatur-Gastransportvorrichtung (1) nach einem der Ansprüche 1 bis 3, wobei ein Spalt (g0) zwischen der Resonanzplatte (12) und dem piezoelektrischen Aktuator (13) gebildet wird.

5. Die Miniatur-Gastransportvorrichtung (1) nach einem der Ansprüche 1 bis 4, wobei der piezoelektrische Aktor (13) umfasst:
eine Aufhängungsplatte (131) mit einer ersten Oberfläche (131a) und einer gegenüberliegenden zweiten Oberfläche (131b), wobei die Aufhängungsplatte (131) eine gekrümmte Schwingung erfahren darf;
ein Außenrahmen (132), der um die Aufhängungsplatte (131) herum angeordnet ist;
mindestens eine Halterung (134), die zwischen der Aufhängungsplatte (131) und dem äußeren Rahmen (132) verbunden ist, um die Aufhängungsplatte (131) elastisch zu stützen; und
ein piezoelektrisches Element (133), wobei die Länge einer Seite des piezoelektrischen Elements (133) kleiner oder gleich der Länge einer Seite der Aufhängungsplatte (131) ist, und das piezoelektrische Element (133) an der zweiten Oberfläche (131b) der Aufhängungsplatte (131) befestigt ist, wobei das piezoelektrische Element (133) eine kurvenförmige Schwingung der Aufhängungsplatte (131) auslöst, wenn es an eine Spannung angelegt wird.

6. Die Miniatur-Gastransportvorrichtung (1) nach einem der Ansprüche 1 bis 5, wobei die Miniatur-Gastransportvorrichtung (1) ferner mindestens eine Isolierplatte (141, 142) und eine leitende Platte (15) umfasst, wobei die mindestens eine Isolierplatte (141, 142) und die leitende Platte (15) nacheinander unter dem piezoelektrischen Aktuator (13) angeordnet sind.

7. Die Miniatur-Gastransportvorrichtung (1) nach Anspruch 6, wobei der äußere Rahmen (132) des piezoelektrischen Aktuators (13) einen ersten leitenden Stift (132a) und die leitende Platte (15) einen zweiten leitenden Stift (151) aufweist, und das Abdeckelement (16) eine Öffnung (163) umfasst, die dem Entlüftungsabschnitt (114) der Gasauslassplatte (11) entspricht, wobei der erste leitende Stift (132a) und der zweite leitende Stift (151) aus der Öffnung (163) des Abdeckelements (16) vorstehen, um mit einer externen Stromquelle elektrisch verbunden zu werden.

8. Die Miniatur-Gastransportvorrichtung (1) nach einem der Ansprüche 5 bis 7, wobei die Aufhängungsplatte (131) ferner eine Ausbuchtung (131e) aufweist und die Ausbuchtung (131e) auf der ersten Oberfläche (131a) der Aufhängungsplatte (131) ausgebildet ist.

9. Die Miniatur-Gastransportvorrichtung (1) nach einem der Ansprüche 5 bis 8, wobei die Ausbuchtung (131e) der Aufhängungsplatte (131) ein Zylinder ist.

10. Die Miniatur-Gastransportvorrichtung (1) nach Anspruch 5, wobei zwischen dem mindestens einen Bügel (134), der Aufhängungsplatte (131) und dem Außenrahmen (132) mindestens ein freier Raum (135) gebildet wird.

11. Die Miniatur-Gastransportvorrichtung (1) nach den Ansprüchen 5 bis 10, wobei zwei Enden des mindestens einen Bügels (134) mit dem äußeren Rahmen (132) bzw. der Aufhängungsplatte (131) verbunden sind.

## Revendications

1. Un dispositif miniature de transport de gaz (1), comprenant:
une plaque de sortie de gaz (11) comprenant un tuyau de sortie de gaz (111), un trou de sortie de gaz (112) et plusieurs structures de saillie (113), dans lequel le tuyau de sortie de gaz (111) est disposé sur une première surface (11a) de la plaque de sortie de gaz (11), et le trou de sortie de gaz (112) est formé dans le tuyau de sortie de gaz (111) et traverse la plaque de sortie de gaz (11) pour évacuer un gaz à partir du dispositif miniature de transport de gaz (1), dans lequel les multiples structures de saillie (113) sont disposées sur une seconde surface (11b) de la plaque de sortie de gaz (11), et un espace entre toutes les deux structures de saillie adjacentes (113) de la pluralité de structures de saillie (113) définissent une partie d'évent (114);
une plaque de résonance (12) comprenant une ouverture centrale (120) correspondant au trou de sortie de gaz (112) de la plaque de sortie de gaz (111);
un actionneur piézoélectrique (13) correspondant à la plaque de résonance (12); et
un élément de couverture (16) comprenant une plaque inférieure (162),
dans lequel la plaque de sortie de gaz (11), la plaque de résonnance (12), l'actionneur piézoélectrique (13) et l'élément de couverture (16) sont empilés les uns sur les autres, de manière séquentielle pour le positionnement, une chambre de convergence (17a) est formée entre la plaque de sortie de gaz (11) et la plaque de résonnance (12), et une première chambre (17b) est formée entre l'élément de couverture (16) et la plaque de résonance (12), dans lequel lorsque l'actionneur piézoélectrique (13) est actionné pour effectuer une opération de collecte de gaz, le gaz converge à l'intérieur de la chambre de convergence (17a), transféré dans la première chambre (17b) via l'ouverture centrale (120) de la plaque de résonance (12), et stocké temporairement dans la première chambre (17b), dans lequel lorsque l'actionneur piézoélectrique (13) est actionné pour effectuer une opération de libération de gaz, le gaz est transféré de la première chambre (17b) vers la chambre de convergence (17a) via l'ouverture centrale (120) de la plaque de résonance (12) et libéré du trou de sortie de gaz (112), **caractérisé en ce que** :
- un espace entre deux structures en saillie adjacentes (113) de la pluralité de structures en saillie (113) est définie comme une partie d'évent (114) ;
- l'élément de couverture (16) comporte une paroi latérale (161) faisant saillie depuis les bords de la plaque inférieure (162), un espace de logement (16a) étant défini de manière collaborative par la paroi latérale (161) et la plaque inférieure (162), et la plaque de résonance (12) et l'actionneur piézoélectrique (13) sont logés à l'intérieur de l'espace de logement (16a),
- le dispositif est configuré de façon à ce que lorsque l'actionneur piézoélectrique (13) est actionné pour effectuer une opération de collecte de gaz, le gaz converge à l'intérieur de la chambre de convergence (17a) via la partie d'évent (114).

2. Le dispositif miniature de transport de gaz (1) selon la revendication 1, dans lequel les structures de saillie (113) sont disposées sur plusieurs coins de la plaque de sortie de gaz (11), et les structures de saillie (113) font saillie à partir des coins correspondants du gaz plaque de sortie (11).

3. Le dispositif miniature de transport de gaz (1) selon la revendication 1 ou 2, dans lequel les structures de saillie (113) sont intégralement formées avec la plaque de sortie de gaz (11).

4. Le dispositif miniature de transport de gaz (1) selon l'une quelconque des revendications 1 à 3, dans lequel un espace (g0) est formé entre la plaque de résonance (12) et l'actionneur piézoélectrique (13).

5. Le dispositif miniature de transport de gaz (1) selon l'une quelconque des revendications 1 à 4, dans lequel l'actionneur piézoélectrique (13) comprend:
une plaque de suspension (131) ayant une première surface (131a) et une seconde surface opposée (131b), dans laquelle la plaque de suspension (131) peut subir une vibration sinueuse;
un cadre extérieur (132) disposé autour de la plaque de suspension (131);
au moins un support (132) connecté entre la plaque de suspension (131) et le cadre extérieur (132) pour supporter élastiquement la plaque de suspension (131); et
un élément piézoélectrique (133), dans lequel la longueur d'un côté de l'élément piézoélectrique (133) est inférieure ou égale à la longueur d'un côté de la plaque de suspension (131), et l'élément piézoélectrique (133) est fixé sur la seconde surface (131b) de la plaque de suspension (131), dans lequel l'élément piézoélectrique (133) entraîne une vibration sinueuse de la plaque de suspension (131) lorsqu'il est soumis à une tension.

6. Le dispositif miniature de transport de gaz (1) selon l'une quelconque des revendications 1 à 5, dans lequel le dispositif miniature de transport de gaz (1) comprend en outre au moins une plaque isolante (141, 142) et une plaque conductrice (15), dans laquelle la ou les plaque(s) isolante(s) (141, 142) et la plaque conductrice (15) sont disposées séquentiellement sous l'actionneur piézoélectrique (13).

7. Le dispositif miniature de transport de gaz (1) selon la revendication 6, dans lequel le cadre extérieur (132) de l'actionneur piézoélectrique (13) comprend une première broche conductrice (132a), la plaque conductrice (15) comprend une seconde broche conductrice (151), et l'élément de couverture (16) comprend une ouverture (163) correspondant à la partie d'évent (114) de la plaque de sortie de gaz (11), dans lequel la première broche conductrice (132a) et la seconde broche conductrice (151) sont saillantes hors de l'ouverture (163) de l'élément de couverture (16) de manière à être connecté électriquement à une source d'alimentation externe.

8. Le dispositif miniature de transport de gaz (1) selon l'une quelconque des revendications 5 à 7, dans lequel la plaque de suspension (131) comprend en outre un renflement (131e), et le renflement (131e) est formé sur la première surface (131a) du plaque de suspension (131).

9. Le dispositif miniature de transport de gaz (1) selon l'une quelconque des revendications 5 à 8, dans lequel le renflement (131e) de la plaque de suspension (131) est un cylindre.

10. Le dispositif miniature de transport de gaz (1) selon la revendication 5, dans lequel au moins un espace libre (135) est formé entre la ou les support(s) (134), la plaque de suspension (131) et le cadre extérieur (132).

11. Le dispositif miniature de transport de gaz (1) selon l'une quelconque des revendications 5 à 10, dans lequel deux extrémités du ou des support(s) (134) sont connectées au cadre extérieur (132) et à la plaque de suspension (131), respectivement.
